**Europäisches Patentamt**

**European Patent Office**

**Office européen des brevets**

(11) Veröffentlichungsnummer: **0 123 644**

**A1**

## (12) EUROPÄISCHE PATENTANMELDUNG

(21) Anmeldenummer: 84730027.4

(22) Anmeldetag: 23.03.84

(51) Int. Cl.³: **H 01 L 31/02**
**H 01 L 31/10, H 01 L 31/18**

(30) Priorität: 25.03.83 DE 3311511

(43) Veröffentlichungstag der Anmeldung:
**31.10.84 Patentblatt 84/44**

(84) Benannte Vertragsstaaten:
**DE FR GB IT NL SE**

(71) Anmelder: **Heinrich-Hertz-Institut für**
**Nachrichtentechnik Berlin GmbH**
**Einsteinufer 37**
**D-1000 Berlin 10(DE)**

(72) Erfinder: **Grote, Norbert, Dr.-Ing.**
**Angerburger Allee 15**
**D-1000 Berlin 19(DE)**

(72) Erfinder: **Niggebrügge, Udo, Dr.-Ing.**
**Lüdtgeweg 12**
**D-1000 Berlin 10(DE)**

(72) Erfinder: **Bach, Heinz-Gunter, Dr.-Ing.**
**Bahnhofstrasse 4**
**D-1000 Berlin 49(DE)**

(74) Vertreter: **Wolff, Konrad**
**Heinrich-Hertz-Institut für Nachrichtentechnik Berlin**
**GmbH Einsteinufer 37**
**D-1000 Berlin 10(DE)**

(54) **Bauelement der integrierten Optik mit einer transparenten Elektrode aus CdO und Verfahren zur Herstellung eines solchen Bauelements.**

(57) Bauelement der integrierten Optik mit einer transparenten Elektrode aus CdO und Verfahren zur Herstellung eines solchen Bauelements .

Für die optische Nachrichtentechnik zeichnet sich der Einsatz monomodaler Systeme mit Wellenlängen im 1,3 $\mu$m-Bereich ab. Hierfür werden Bauelemente, elektronische und optische in monolithischer Integration, benötigt. Für diesen Wellenlängenbereich ist das InP-Materialsystem — InP, GaInAsP — besonders gut geeignet. CdO, das für diese Wellenlängen transparent ist, bietet sich wegen seiner elektrischen Eigenschaften als Elektrodematerial an. Problematisch sind dabei CdOInP übergänge wegen z.B. zu geringer Barrierenhöhen. Die Erfindung schafft Abhilfe, indem eine transparente CdO-Elektrode nach Art eines oxidunterstützten Schottky-Kontaktes auf InP-Material aufgebaut wird. Hierzu ist eine Plasma-Oxidation, sodann eine die Stöchiometrie erhaltende Zerstäubung des CdO und schließlich eine Temperung durchzuführen.

Fig.1

**0123644**

HEINRICH-HERTZ-INSTITUT FÜR NACHRICHTENTECHNIK BERLIN
GMBH                                           13/0383 EP

Bauelement der integrierten Optik mit einer transparenten Elektrode aus CdO und Verfahren zur Herstellung eines solchen Bauelements

Die Erfindung bezieht sich auf ein Bauelement der integrierten Optik mit einer transparenten Elektrode aus Cadmiumoxid - CdO - und auf ein besonders angepaßtes Verfahren zur Herstellung eines solchen Bauelements.

Die bisherigen Entwicklungen in der optischen Nachrichtentechnik geben für das Gebiet der integrierten Bauelemente einige Randbedingungen vor, die sich auf das zum Einsatz gelangende Materialsystem und damit auch auf die anzuwendenden Technologien auswirken. So zeichnet sich beispielsweise der Einsatz monomodaler optischer Systeme mit Wellenlängen im 1,3 µm-Bereich für die Nachrichtentechnik ab. Dafür werden - nach wie vor - rein elektronische Bauelemente, insbesondere Transistoren, und Lichtwellen emittierende und empfangende bzw. absorbierende Bauelemente, also Laser und Photodioden, sowie auch optisch oder elektrisch steuerbare, rein oder gemischt optische und elektronische Bauelemente benötigt.

Aus "IEEE Journal of Quantum Electronics", Band QE-18, Nr. 4, April 1982, Seiten 763 bis 766 (F.K. Reinhart et al) sind Rippenwellenleiter mit mehreren Elektroden für elektrooptische Polarisationsmodulation bekannt. Diese Bauelemente basieren auf dem AlGaAs-Materialsystem und sind für den 1 µm-Wellenlängenbereich konzipiert. Für eine transparente Elektrode wurde dabei CdO eingesetzt. Für die Deposition des CdO wurde zuvor für eine möglichst saubere Oberfläche gesorgt, d.h. sorgfältig Photolack und anodisiertes Oxid entfernt (siehe a.a.O., S. 763 rechte Spalte unten).

Die Besonderheit von CdO für den Einsatz als transparente Elektrode besteht darin, daß die Vorzüge eines Metalls hinsichtlich der elektrischen Eigenschaften nahezu erreicht, die Nachteile bezüglich der großen Dämpfung von Lichtwellen bei Metallen hingegen vermieden werden. Im oben erwähnten Aufsatz (siehe dort, Seite 766 linke Spalte Zeilen 14 bis 16) findet sich auch der Hinweis, daß derartige Bauelemente auch auf anderen Halbleiterverbindungen, insbesondere auch auf dem GaInAsP-InP Materialsystem basieren können.

Hier nun setzt die Erfindung ein. Dazu ist folgendes zu berücksichtigen. Für Heteroverbindungen sind Barrierenhöhen von mindestens 0,63 eV erwünscht. Auf der Basis GaAs lassen sich 0,8 eV ohne weiteres erreichen, bei InP/GaInAsP sind - ohne besondere Maßnahmen - mit allen reinen Metallen die Barrierenhöhen jedoch sehr viel geringer, nämlich etwa 0,45 bis 0,55 eV. Metallische Kontakte bei elektronischen Bauelementen lassen sich als oxidunterstützte Schottky-Kontakte aufbauen (siehe z.B. "Electronics Letters", 14. Sept. 1978, Band 14, Nr. 19, Seiten 643/644, insbesondere Seite 643 rechte Spalte 5. Absatz, bzw. "Applied Physics Letters", Jg. 32 Nr. 9, 1. Mai 1978, Seiten 578 bis 581, insbesondere Seite 580 linke Spalte 3. und 4. Absatz). Hinweise darauf, ob derartige Maßnahmen auch für die Herstellung transparenter Elektroden aus CdO oder anderen Metalloxiden für optische Bauelemente anwendbar sein könnten, finden sich dort allerdings nicht.

Wesentlich für die Erfindung und die ihr zugrundeliegende Aufgabenstellung ist nach alledem, ein Bauelement der integrierten Optik mit einer transparenten Elektrode aus CdO zur Verfügung zu stellen, bei dem ein Materialsystem eingesetzt wird, das für den vorgegebenen Wellenlängenbereich - etwa 1,3 μm - besonders gut geeignet ist, und bei dem ein Kontaktaufbau, der die erforderlichen elektrischen Eigenschaften aufweist, durch technologische Maßnahmen bei der Herstellung ermöglicht wird.

Dies wird gemäß der Erfindung bei einem solchen Bauelement dadurch erreicht, daß das Bauelement auf dem InP-Materialsystem (InP, GaInAsP) basiert und die transparente Elektrode nach Art eines oxidunterstützten Schottky-Kontaktes aufgebaut ist. Ausgehend von dem bekannten Bauelement der integrierten Optik auf der Basis GaAs/AlGaAs mit einer transparenten Elektrode aus CdO ergibt sich für die Erfindung, daß ein solches Bauelement auch auf der Basis InP/GaInAsP mit verhältnismäßig aufwandarmen, zusätzlichen technologischen Maßnahmen hergestellt werden kann; ausgehend von bekannten elektronischen Bauelementen auf der Basis InP/GaInAsP besteht das überraschende Ergebnis darin, daß auch mit CdO, also keinem reinen Metall, das ähnlich gute elektrische Eigenschaften wie ein Metall aufweist, für den vorgegebenen Wellenlängenbereich jedoch transparent ist, Lichtwellen dort also nicht bzw. kaum dämpft, der Aufbau nach Art eines oxidunterstützten Schottky-Kontaktes möglich ist. Selbstverständlich sind die Herstellungsbedingungen, d.h. für jeden Schritt die anzuwendenden Temperaturen, Drücke, Zeiten, umgebende Medien, Depositionsverfahren usw. aus einer Vielzahl bekannter Möglichkeiten entsprechend auszuwählen und mit Hilfe geeigneter Messungen zu optimieren. Hierauf wird weiter unter noch näher eingegangen.

Bei bevorzugten Ausführungsformen der Erfindung, die eine Wellenleitung oder - allgemeiner ausgedrückt - eine ausgeprägte Brechzahldifferenz aufweisen sollen, kann $n^+$-InP als Trägermaterial und $n^-$-InP als wellenleitende Schicht eingesetzt werden. Die unterschiedlichen Dotierungen bewirken unterschiedliche Brechzahlen. Bei anderen vorteilhaften Ausführungsformen der Erfindung, bei denen auf wellenleitende Eigenschaften zugunsten anderer optoelektrischer Erscheinungen, z.B. bezüglich einer optischen Steuerung eines Transistors, die Schwerpunkte verschoben werden, kann InP - mit entsprechender bzw. ohne besondere Dotierung - als Trägermaterial und $n^-$-GaInAsP als aktive Schicht eingesetzt werden.

Bei den für den 1,3 μm Wellenlängenbereich konzipierten Ausführungsformen der Erfindung, die als ausgesprochene Rippenwellenleiter ausgebildet sind, weisen die Abmessungen einer von der wellenleitenden Schicht gebildeten Rippe etwa folgende Werte auf: die Länge beträgt einige mm, die Breite etwa 2 bis 5 μm und die Stufenhöhe etwa 0,1 μm. Bei diesen Abmessungen stehen die elektrischen Größen und die optischen Wirkungen in einem solchen Bauelement in optimalem Verhältnis zueinander.

Von vorteilhafter Bedeutung für Ausführungsformen der Erfindung kann weiterhin eine Metallisierung auf der transparenten CdO-Elektrode sein. Damit läßt sich auf jeden Fall eine Verbesserung der Zuleitung bei hohen Frequenzen (GHz), und bei der Ausbildung elektrischer Größen, z.B. Äquipotentialflächen auf der Steuerelektrode erzielen. Eine solche Metallisierung kann etwa 0,2 μm bis 0,5 μm betragen, wobei diese Werte je nach den gestellten Anforderungen ohne weiteres auch mehr oder weniger über- oder unterschritten werden können.

In diesem Zusammenhang steht noch eine weitere, besonders bevorzugte Ausführungsform der Erfindung, die eine Lichtdurchtrittsöffnung in der Metallisierung aufweist. Derartige Bauelemente können beispielsweise als Photodioden oder als optisch steuerbare Transistoren oder dgl. eingesetzt werden.

Bei Ausführungsformen der Erfindung wird ein Gegenkontakt zweckmäßig auf der Unterseite des Trägermaterials angeordnet. Andere Stellen sind natürlich nicht ausgeschlossen und können entsprechend den Anforderungen und im Rahmen der vorhandenen Möglichkeiten gewählt werden.

Wie bereits weiter oben schon erwähnt, kommt den technologischen Maßnahmen bei der Herstellung eines Bauelements der integrierten Optik, das auf dem InPGaInAsP-Materialsystem basiert und eine nach Art eines oxidunterstützten Schottky-Kontaktes aufgebaute transparente Elektrode aus CdO aufweist, eine wesentliche Bedeutung zu. Diese läßt sich dahingehend zusammenfassen, daß gemäß der Erfindung nach Ablagerung der wellenleitenden $n^-$-Schicht ($n^-$-InP, $n^-$-GaInAsP) auf dem Trägermaterial ($n^+$-InP, InP mit beliebiger Dotierung) eine Plasma-Oxidation durchgeführt wird, sodann die Deposition von CdO durch eine die Stöchiometrie erhaltende Zerstäubung erfolgt und schließlich eine Temperung vorgenommen wird.

Die Plasma-Oxidatin als solche wird auch bei der Herstellung von oxidunterstützten metallischen Schottky-Kontakten vorgenommen, und zwar bei elektronischen Bauelementen, die auf dem InP-Materialsystem basieren. Die Verfahrensbedingungen sind bei diesem Schritt jedoch auf den nachfolgenden Ablauf des Herstellungsver-

0123644

fahrens anzupassen, also in allen Einzelheiten spezifisch festzulegen. Dabei kann nicht ausgeschlossen werden, daß dieses oder jenes Detail eines Verfahrensschrittes mit bekannten Einzelheiten, dann aber wohl mehr zufällig, übereinstimmen. Bei der praktischen Durchführung im Labor wurde hierfür ein Tunnel-Reaktor eingesetzt, der bei 13,56 MHz mit 200 W arbeitet. Das Plasmagas bestand aus reinem Sauerstoff ($O_2$).

Für die Deposition von Cadmiumoxid (CdO) kommen wegen der stöchiometrischen Probleme nur solche Technologien in Betracht, bei denen eine Zersetzung der Moleküle z.B. infolge thermischer Bewegungen ausgeschlossen werden kann. Es müssen also sogenannte "kalte" Verfahren sein, d.h. es sollte nicht über 350 °C gearbeitet werden. Gegenüber der bekannten Herstellung metallischer oxidunterstützter Schottky-Kontakte besteht bei der Erfindung insofern ein wesentlicher Unterschied, als bei reinen Elementen thermische Bewegungen nicht schädlich, bei Verbindungen wie Cadmiumoxid, thermische Dissoziationen hingegen bezüglich der Erhaltung der Stöchiometrie hinderlich sind.

Auch die Temperung ist für das erfindungsgemäße Herstellungsverfahren wesentlich. Dies wird weiter unten im Zusammenhang mit der Beschreibung der Zeichnungen noch näher erläutert.

Im einzelnen haben sich für die einzelnen Verfahrensschritte folgende Bedingungen als vorteilhaft erwiesen:
- Die Plasma-Oxidation sollte bei ca. 0,8 mbar ($O_2$-Plasma) für die Dauer von etwa 10 bis 60 Minuten durchgeführt werden. Eine gezielte Temperaturbeeinflussung ist dabei nicht erforderlich.

- Die Deposition von Cadmiumoxid (CdO) kann in einem Argon- oder Argon-Sauerstoff-Plasma durch Aufsputtern erfolgen. Dabei ist eine Kathodenzerstäubung oder ein anderes "kaltes" Verfahren anzuwenden.

- Die Temperung ist in Stickstofff ($N_2$) bei Temperaturen zwischen 350 °C und 400 °C für die Dauer von 5 bis 30 Minuten vorzunehmen. Temperatur und Zeitdauer beeinflussen sich gegenseitig und sind empirisch aufeinander abzustimmen. Andere inerte Gase sind ebenfalls möglich.

Eine Metallisierung der transparenten Elektrode läßt sich in an sich bekannter und bewährter Weise durch Aufdampfen des Metalles herbeiführen. Dies kann vor oder nach der Temperung erfolgen. Die Ausformung einer Rippe kann schon bei der Ablagerung der aktiven, z.B. wellenleitenden Schicht auf dem Trägermaterial durchgeführt werden. Eine laterale Struktur kann auch später, beispielsweise in einem abschließenden Verfahrensschritt, vorzugsweise durch trockenchemisches Ätzen erzeugt werden.

Nachfolgend wird anhand der schematischen Darstellungen in den Zeichnungen das Wesen der Erfindung noch näher erläutert. Dabei zeigen:

Fig. 1:  einen Querschnitt durch ein Bauelement mit transparenter Elektrode

und  Fig. 2 a) bis d) die Strom-Spannungs-Kennlinien nach verschiedenen Verfahrensbedingungen bei der Herstellung.

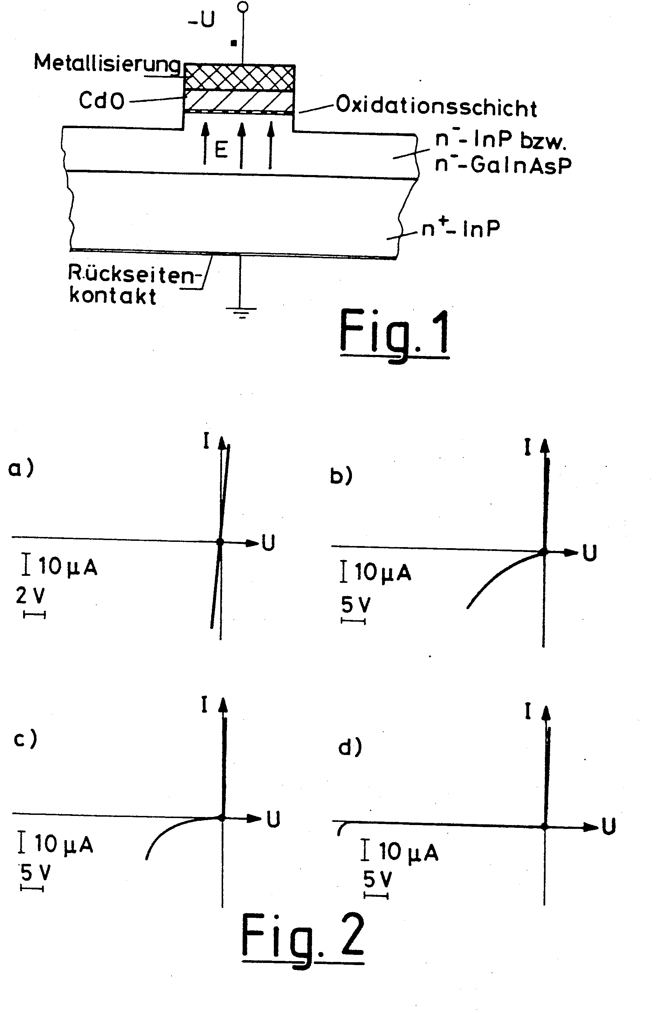

Aus Fig. 1 ist der Aufbau eines Bauelements zu erkennen.

Im dargestellten Beispiel besteht das Trägermaterial aus $n^+$-InP. Darüber befindet sich eine elektrooptisch aktive, wellenleitende Schicht, die aus $n^-$-InP bzw. $n^-$-GaInAsP gebildet worden ist. Diese wellenleitende Schicht hat eine Höhe von ca 1 µm. Von ihr wird gleichzeitig eine Rippe mit einer Stufenhöhe von ca. 0,1 µm gebildet. Den Übergang zu der transparenten Elektrode bildet eine meßtechnisch praktisch nicht erfaßbare dünne Oxidschicht. Die CdO-Schicht ist ca. 0,2 µm dick, die Metallisierung etwa 0,5 µm und kann in weiten Grenzen gewählt werden.

Auf der Unterseite des Trägermaterials befindet sich der Rückseitenkontakt. Bei dem eingezeichneten Spannungspotential - _U an der Metallisierung bzw. der transparenten Elektrode und Rückseitenkontakt auf Masse - bildet sich in der wellenleitenden Schicht insbesondere im Bereich der Rippe ein elektrisches Feld E in der Richtung der eingezeichneten Pfeile aus.

Bauelemente dieser und ähnlicher Art können als Modulatoren, als optische Signalempfänger, als Phototransistoren oder dergleichen aufgebaut und eingesetzt werden.

Die Fig. 2a) bis 2d) zeigen die Strom-Spannungskennlinien von Bauelementen, die bei der Herstellung unterschiedlichen Verfahrensbedingungen unterworfen worden sind. Hierbei sind die sehr bezeichnenden, ausschlaggebenden Schritte, nämlich die Plasma-Oxidation vor dem Aufsputtern der CdO-Schicht und die Temperung nach dem Aufsputtern zur Veranschaulichung ihrer Auswirkungen gewählt worden. Ein Bauelement, das weder einer Plasma-Oxidation noch einer Temperung unterworfen wurde - Fig. 2a - zeigt rein ohmsches Verhalten.

Dies ist für die angestrebten Zwecke völlig unzulänglich.

Aus der Kennlinie in Fig. 2b, die für ein Bauelement aufgenommen wurde, das keiner Plasma-Oxidation, jedoch einer Temperung unterzogen wurde, ist schon eine Dioden-Charakteristik zu erkennen. Ähnliches gilt für Fig. 2c, wobei eine Plasma-Oxidation, jedoch keine Temperung stattfand. Die Auswirkungen der Plasma-Oxidation und der Temperung sind, jede für sich genommen, etwa gleich.

In Fig. 2d ist die Kennlinie für ein Bauelement, das in erfindungsgemäßer Weise hergestellt worden ist, also mit Plasma-Oxidation vor sowie mit Temperung nach dem Aufsputtern der Cadmiumoxidschicht, dargestellt. Es zeigt ausgezeichnete Eigenschaften. Für die Barrierenhöhe wurden 0,64 eV, also der allgemein erwünschte Wert, erreicht. Hierbei war die Idealitätskennzahl n = 1,04. Unter anderen Bedingungen bei der Plasma-Oxidation und der Temperung lassen sich noch größere Barrierenhöhen von 0,8 bis 0,9 eV, dann allerdings bei ungünstigeren Idealitäts-Kennzahlen von n = 2 und größer, erreichen.

Weitere Einzelheiten hierzu sind auch Gegenstand eines Vortrages: "Electrical Properties of CdO/InP Heterojunctions" (Bach, Grote, Niggebrügge) bei "NATO sponsored InP Workshop" 28. bis 30. März 1983, Lancaster, UK.

HEINRICH-HERTZ-INSTITUT FÜR NACHRICHTENTECHNIK BERLIN
GMBH                                    13/0383 EP

Patentansprüche:

1. Bauelement der integrierten Optik mit einer transparenten Elektrode aus CdO,
d a d u r c h   g e k e n n z e i c h n e t ,   daß
das Bauelement auf dem InP-Materialsystem basiert und
die transparente Elektrode nach Art eines oxidunterstützten Schottky-Kontaktes aufgebaut ist.

2. Bauelement nach Anspruch 1, gekennzeichnet durch
$n^+$-InP als Trägermaterial und $n^-$-InP als elektrooptisch aktive, insbesondere wellenleitende Schicht.

3. Bauelement nach Anspruch 1, gekennzeichnet durch
InP als Trägermaterial und $n^-$-GaInAsP als elektrooptisch aktive, insbesondere wellenleitende Schicht.

4. Bauelement nach einem der Ansprüche 1 bis 3,
gekennzeichnet durch eine wellenleitende Schicht mit
einer Rippe von einigen mm Länge, etwa 2 bis 5 µm
Breite und einer Stufenhöhe von etwa 0,1 µm.

5. Bauelement nach einem der Ansprüche 1 bis 4,
gekennzeichnet durch eine Metallisierung auf der transparenten Elektrode.

6. Bauelement nach Anspruch 5, gekennzeichnet durch
eine Schichtdicke der Metallisierung von etwa 0,1 bis
0,5 µm.

7. Bauelement nach Anspruch 5 oder 6, gekennzeichnet
durch eine Lichtdurchtrittsöffnung in der Metallisierung.

8. Bauelement nach einem der Ansprüche 1 bis 7, gekennzeichnet durch einen Gegenkontakt auf der Unterseite des Trägermaterials.

9. Verfahren zur Herstellung eines Bauelements der integrierten Optik, das auf dem InP-Materialsystem basiert und eine nach Art eines oxidunterstützten Schottky-Kontaktes aufgebaute transparente Elektrode aus CdO aufweist, d a d u r c h   g e k e n n z e i c h n e t,   daß nach Ablagerung der elektrooptisch aktiven $n^-$-Schicht auf dem Trägermaterial eine Plasma-Oxidation durchgeführt wird, sodann die Deposition von CdO durch eine die Stöchiometrie erhaltende Bestäubung erfolgt und schließlich eine Temperung vorgenommen wird.

10. Verfahren nach Anspruch 9, dadurch gekennzeichnet, daß die Plasma-Oxidation bei ca. 0,8 mbar für die Dauer von etwa 10 bis 60 Minuten und ohne gezielte Temperaturbeeinflussung durchgeführt wird.

11. Verfahren nach Anspruch 9 und 10, dadurch gekennzeichnet, daß die Deposition von CdO in einem Ar oder $Ar/O_2$ -Plasma durch Aufsputtern erfolgt.

12. Verfahren nach einem der Ansprüche 9 bis 11, dadurch gekennzeichnet, daß die Temperung in Stickstoff bei Temperaturen zwischen 350 und 400 °C für die Dauer von 5 bis 30 Minuten vorgenommen wird.

13. Verfahren nach einem der Ansprüche 9 bis 12, dadurch gekennzeichnet, daß eine Metallisierung der transparenten Elektrode durch Aufdampfen des Metalls herbeigeführt wird.

14. Verfahren nach einem der Ansprüche 9 bis 13, dadurch gekennzeichnet, daß eine Struktur in einem abschließenden Verfahrensschritt vorzugsweise durch trockenchemisches Ätzen erzeugt wird.

**Fig.1**

**Fig.2**

Europäisches
Patentamt

**EUROPÄISCHER RECHERCHENBERICHT**

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl. ³) |
|---|---|---|---|
| A | JOURNAL OF APPLIED PHYSICS, Band 51, Nr. 9, September 1980, New York, USA K. KAMIMURA et al. "InP metal-insulated-semiconductor Schottky contacts using surface oxide layers prepared with bromine water" * Artikel vollständig * | 1,2,8, 13 | H 01 L  31/02<br>H 01 L  31/10<br>H 01 L  31/18 |
| | --- | | |
| A | JOURNAL OF APPLIED PHYSICS, Band 53, Nr. 1, Januar 1982, New York, USA K.P. PANDE et al. "The electrical and photovoltaic properties of tunnel metal-oxide-semiconductor devices built on n-InP substrates" * Artikel vollständig * | 1,2,8, 13 | |
| | | | **RECHERCHIERTE SACHGEBIETE (Int. Cl. ³)** |
| | --- | | |
| A | SOLID-STATE ELECTRONICS, Band 25, Nr. 5, Mai 1982, Exeter, GB O. WADA et al. "InP Schottky contacts with increased barrier height" * Artikel vollständig * | 1,2 | H 01 L  31/02<br>H 01 L  31/06<br>H 01 L  31/10<br>H 01 L  31/18 |
| | --- | | |
| A,D | IEEE JOURNAL OF QUANTUM ELECTRONICS, Band QE-18, Nr. 4, April 1982 K. REINHART et al. "Electrooptic polarization modulation in multielectrode AlxGal-xAs rib waveguides" * Artikel vollständig * | 1,4 | |
| | ---           -/- | | |

Der vorliegende Recherchenbericht wurde für alle Patentansprüche erstellt.

| Recherchenort BERLIN | Abschlußdatum der Recherche 18-06-1984 | Prüfer ROTHER A H J |
|---|---|---|

KATEGORIE DER GENANNTEN DOKUMENTEN
X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur
T : der Erfindung zugrunde liegende Theorien oder.Grundsätze

E : älteres Patentdokument, das jedoch erst am oder nach dem Anmeldedatum veröffentlicht worden ist
D : in der Anmeldung angeführtes Dokument
L : aus andern Gründen angeführtes Dokument
---
& : Mitglied der gleichen Patentfamilie, übereinstimmendes Dokument

EPA Form 1503. 03.82

Europäisches Patentamt

**EUROPÄISCHER RECHERCHENBERICHT**

## EINSCHLÄGIGE DOKUMENTE

| Kategorie | ▶ Kennzeichnung des Dokuments mit Angabe, soweit erforderlich, der maßgeblichen Teile | Betrifft Anspruch | KLASSIFIKATION DER ANMELDUNG (Int. Cl. 3) |
|---|---|---|---|
| A | SOLAR CELLS, Band 7, Nr. 3, Dezember 1982, Amsterdam, NL I. SHIH et al. "A semiconductor-insulator-semiconductor CdO-SiO2-Si solar cell" * Artikel vollständig * | 1 | |
| | --- | | |
| A | JOURNAL OF THE ELECTROCHEMICAL SOCIETY, Band 119, Nr. 6, Juni 1972, Pennington, USA R. MEHTA et al. "Sputtered cadmium oxide and indium oxide/tin oxide films as transparent electrodes to cadmium sulfide" * Artikel vollständig * | 1 | |
| | ----- | | RECHERCHIERTE SACHGEBIETE (Int. Cl. 3) |

Der vorliegende Recherchenbericht wurde für alle Patentansprüche erstellt.

| Recherchenort BERLIN | Abschlußdatum der Recherche 18-06-1984 | Prüfer ROTHER A H J |
|---|---|---|

KATEGORIE DER GENANNTEN DOKUMENTEN
X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur
T : der Erfindung zugrunde liegende Theorien oder Grundsätze

E : älteres Patentdokument, das jedoch erst am oder nach dem Anmeldedatum veröffentlicht worden ist
D : in der Anmeldung angeführtes Dokument
L : aus andern Gründen angeführtes Dokument

& : Mitglied der gleichen Patentfamilie, übereinstimmendes Dokument

EPA Form 1503 03 82